# EUROPEAN PATENT APPLICATION

(11) **EP 2 708 905 A2**
(43) Date of publication of application: **19.03.2014**
(21) Application number: 13166064.9
(22) Date of filing: 30.04.2013
(51) Int. Cl.: G01R 31/04

(54) **Electronic apparatus and method of testing a connector**

(30) Priority: 14.09.2012 KR 20120101952
(71) Applicant: Samsung Electronics Co., Ltd, Gyeonggi-do 443-742 (KR)
(72) Inventor: Kim, Sung-woo, Gyeonggi-do (KR); Lee, Jung-min, Seoul (KR)
(74) Representative: Walaski, Jan Filip

(57) **Abstract**

An electronic apparatus and a method of controlling the same are provided. The electronic apparatus includes a connector that includes two or more pins to be connected with an external device and transmits and receives a signal to and from the external device, a signal processor that generates a test signal for testing the connector and outputs the test signal to a first pin among the two or more pins, and a controller that determines whether the connector is defective in accordance with characteristics of the test signal received through a second pin short-circuited with the first pin by a short-circuit assistor among the two or more pins. Thus, time for testing a connector of the electronic apparatus is shortened to thereby enhance productivity.

## Description

The present invention relates to an electronic apparatus and a method of controlling the same, and more particularly to an electronic apparatus and a method of controlling the same in which time for testing a connector of the electronic apparatus is shortened to enhance productivity.

To test a terminal of an electronic apparatus, external equipment has been used.

The external equipment may be directly connected to the terminal of the electronic apparatus and generate a signal. The generated signal may be input to the electronic apparatus through the terminal and used for testing the terminal.

However, the external equipment needs to be connected to, and disconnected from the terminal, a signal needs to be generated and inputted, etc. Therefore, it takes a considerable amount of time to test the terminal of the electronic apparatus. The time used in testing is used even in a case of a not defect found (NDF), thereby deteriorating productivity.

Additional aspects and/or advantages will be set forth in part in the description which follows and, in part, will be apparent from the description, or may be learned by practice of the invention.

According to an exemplary embodiment an electronic apparatus and a method of controlling the same, in which time for testing a connector of the electronic apparatus is shortened to thereby improve productivity are provided.

According to an aspect of an exemplary embodiment, an electronic apparatus includes a connector that includes two or more pins to be connected with an external device and transmits and receives a signal to, and from, the external device, a signal processor that generates a test signal for testing the connector and outputs the test signal to a first pin among the two or more pins, and a controller that determines whether the connector is defective in accordance with characteristics of the test signal received through a second pin short-circuited with the first pin by a short-circuit assistor among the two or more pins.

The electronic apparatus may include a short-circuit assistor.

The electronic apparatus may further a display.

Whether the connector is defective may be output to, and displayed on, the display.

The electronic apparatus may further include a storage that stores information about the test signal.

The test signal may include a digital signal, and have a characteristic of a digital value.

The test signal may include an analog signal, and have a characteristic of a frequency.

The test signal may include at least one test signal, and be output to the two or more pins at a time.

The short-circuit assistor may have a structure for sorting and short-circuiting the two or more pins in accordance with characteristics of the output test signals.

The short-circuit assistor may have a structure shaped like a cover provided separately from the electronic apparatus and connected to the connector.

According to an aspect of an exemplary embodiment, a control method of an electronic apparatus includes short-circuiting two or more pins that are to be connected with an external device and transmit and receive a signal to and from the external device, generating a test signal for testing the connector and outputting the test signal to a first pin among the two or more pins; and determining whether the connector is defective in accordance with characteristics of the test signal received through a second pin short-circuited with the first pin by a short-circuit assistor among the two or more pins.

The short-circuiting the two or more pins may include connecting the short-circuit assistor to the connector.

The electronic apparatus may include a display.

The connector is defective may be output to, and displayed on, the display.

The control method may include storing information about the test signal, wherein the outputting the test signal includes generating the test signal based on the stored information.

The test signal may include a digital signal, and may have a characteristic of a digital value.

The test signal may include an analog signal, and have a characteristic of a frequency.

The test signal may include at least one test signal, and is output to the two or more pins at a time.

The short-circuit assistor may sort and short-circuit the two or more pins in accordance with characteristics of the output test signals.

The short-circuit assistor may be provided separately from the electronic apparatus and connected to the connector.

The above and/or other aspects will become apparent and more readily appreciated from the following description of exemplary embodiments, taken in conjunction with the accompanying drawings, in which:
FIG. 1 illustrates an electronic apparatus according to an exemplary embodiment;
FIG. 2 illustrates an electronic apparatus according to an exemplary embodiment;
FIG. 3 illustrates an electronic apparatus according to an exemplary embodiment;
FIG. 4 illustrates an exemplary test signal is applied between a signal processor and a connector short-circuited by a short-circuit assistor according to an exemplary embodiment;
FIG. 5 illustrates an exemplary test result from applying a test signal;
FIG. 6 illustrates and exemplary test signal that is applied between a signal processor and a connector short-circuited by a short-circuit assistor according to an exemplary embodiment;
FIG. 7 illustrates an exemplary test result from applying a test signal;
FIG. 8 illustrates an exemplary control flowchart of an electronic apparatus according to an exemplary embodiment; and
FIG. 9 illustrates an exemplary control flowchart of an electronic apparatus according to an exemplary embodiment.

Exemplary embodiments are described in detail with reference to accompanying drawings.

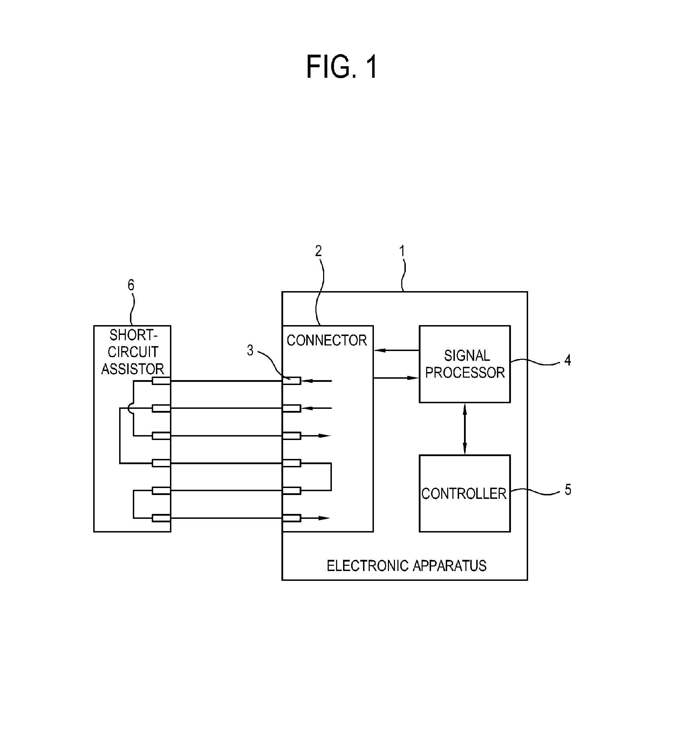

FIG. 1 illustrates an electronic apparatus according to an exemplary embodiment.

As illustrated in FIG. 1, the electronic apparatus 1 according to an exemplary embodiment includes a connector 2 including two or more pins 3 to which an external device (not shown) may be connected and which is used for transmitting and receiving a signal to and from the external device. A signal processor 4 generates a test signal for testing the connector 2 and outputs the signal through a first pin 3 among the two or more pins 3. A controller 5 determines whether the connector 2 is defective, for example, in accordance with characteristics of the test signal received through a second pin 3 short-circuited with the first pin 3 by a short-circuit assistor 6 among the two or more pins 3.

An electronic apparatus may include a television, a monitor or the like display apparatus, but is not limited thereto. Any electronic apparatus may be applicable as long as it has a connector, for example, such as a terminal or a port.

The connector 2 may be a terminal having a plurality of pins, through which the electronic apparatus 1 connects with an external device so as to transmit and receive a signal. The signal transmitted and received may include a video signal, an audio signal, a data signal, a power signal, etc. The plurality of pins 3 included in the connector 2 may be configured to correspond to signals and ground, respectively. Accordingly, the short-circuit assistor 6 to be may be provided to sort these pins included in the connector 2 in accordance with signals and to short-circuit them.

The short-circuit assistor 6 may be provided separately from the electronic apparatus 1, and used in producing the electronic apparatus 1 in order to determine whether the connector 2 is defective. Because the short-circuit assistor 6 may be used in the production stage in order to determine whether the connector 2 of the electronic apparatus 1 is defective, the assistor does not need to be part of the internal configuration of the electronic apparatus 1. The short-circuit assistor 6 may have a cap structure for covering the connector 2, and be shaped corresponding to the shape of the connector 2. The short-circuit assistor 6 may have a wiring pattern (not shown) that not only covers the connector 2, but also electrically connects the pins 3. The wiring pattern may be provided to electrically short-circuit the pins when the short-circuit assistor 6 is coupled to the connector 2.

The signal processor 4 generates the test signal to be transmitted to the connector 2 under control of the controller 5. The test signal may be a digital signal having a digital value, or an analog signal having a predetermined frequency. A number of pins through which the test signal passes may be at least two. In the case of the digital signal, the test signal may include a signal having a high or low level. In the case of the analog signal, the test signal may have a predetermined frequency. The signal processor 4 outputs the test signal to one of the plural pins 3, and receives the test signal through another pin short-circuited with the pin 3. That is, the signal processor 4 receives the test signal passed through a closed circuit formed by the short-circuit of the pins 3.

The controller 5 controls the signal processor 4 to output and receive the test signal when the pins 3 of the connector 2 are short-circuited by the short-circuit assistor 6. If the received test signal and the output test signal are the same, the controller 5 determines that the connector 2 has no defect. On the other hand, if the received test signal and the output test signal are different from each other, the controller 5 may determine that the connector 2 is defective.

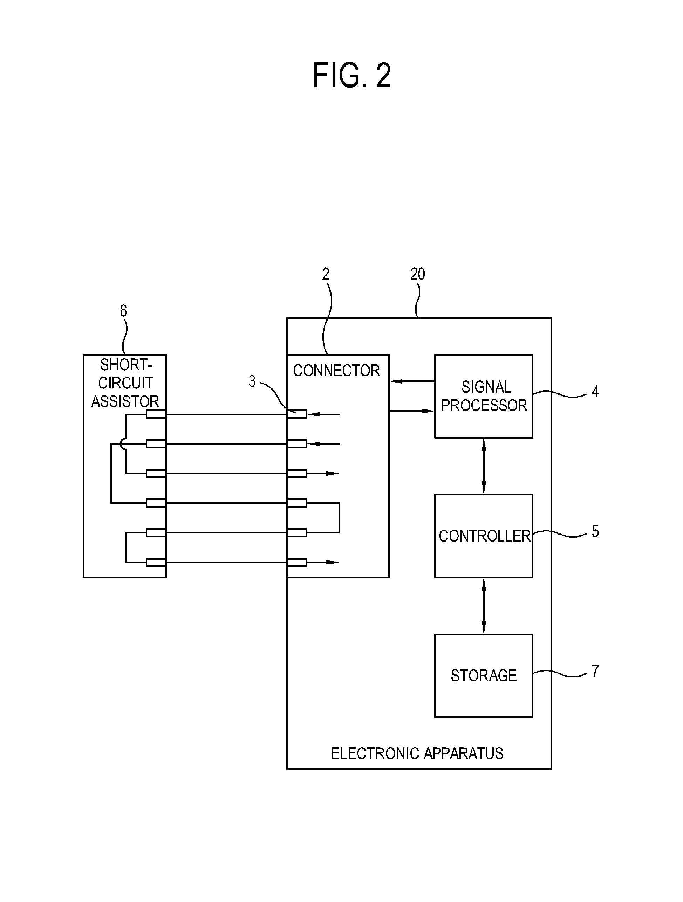

FIG. 2 illustrates an electronic apparatus 20 according to an exemplary embodiment.

As part of an exemplary embodiment, the electronic apparatus may include a storage 7.

The storage 7 stores information corresponding to the test signal. The storage 7 may include a look-up table based on the plurality of test signals in order to determine whether the connector 2 is defective in accordance with change in the test signal. Thus, the signal processor 4 may generate the test signal based on the information stored in the storage 7. For example, the information about the test signal stored in the storage 7 may be provided as many as the number of closed circuits that can be formed in the connector 2 short-circuited by the short-circuit assistor 6, so that the signal processor 4 can output the number of test signals corresponding to the number of closed circuits.

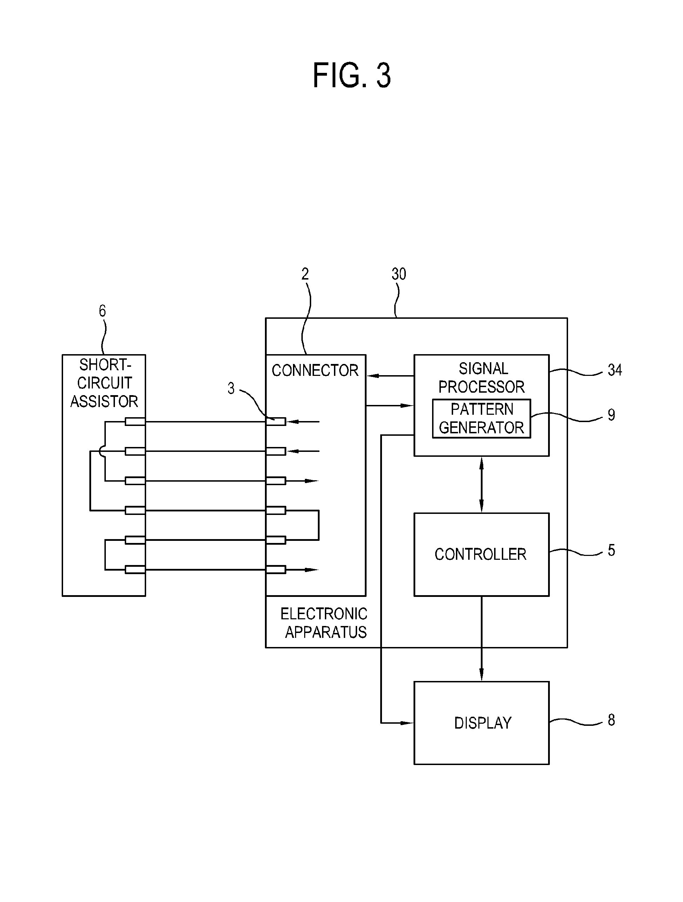

FIG. 3 illustrates an electronic apparatus 30 according to an exemplary embodiment.

In this exemplary embodiment, the electronic apparatus includes a display 8 and a pattern generator 9 as compared with that of the exemplary embodiment illustrated in FIG. 1.

The display 8 may display whether the connector 2 is defective, under control of the controller 5.

The signal processor 34 may include the pattern generator 9 to generate an image having a predetermined pattern corresponding to determination of the received test signal.

Accordingly, a worker can inspect whether the connector 2 is defective, through an image having a predetermined pattern displayed on the display 8.

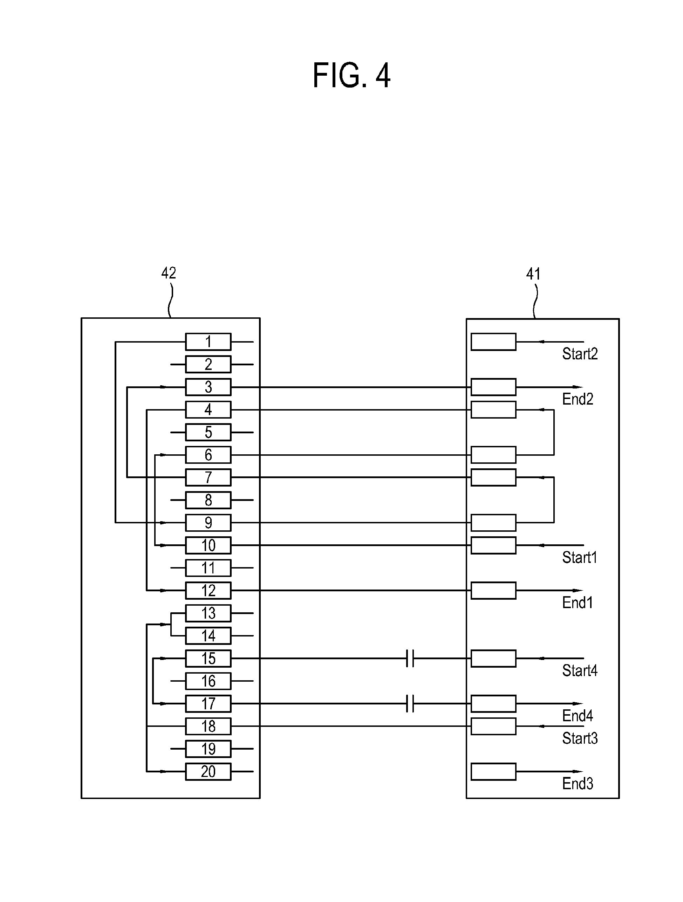

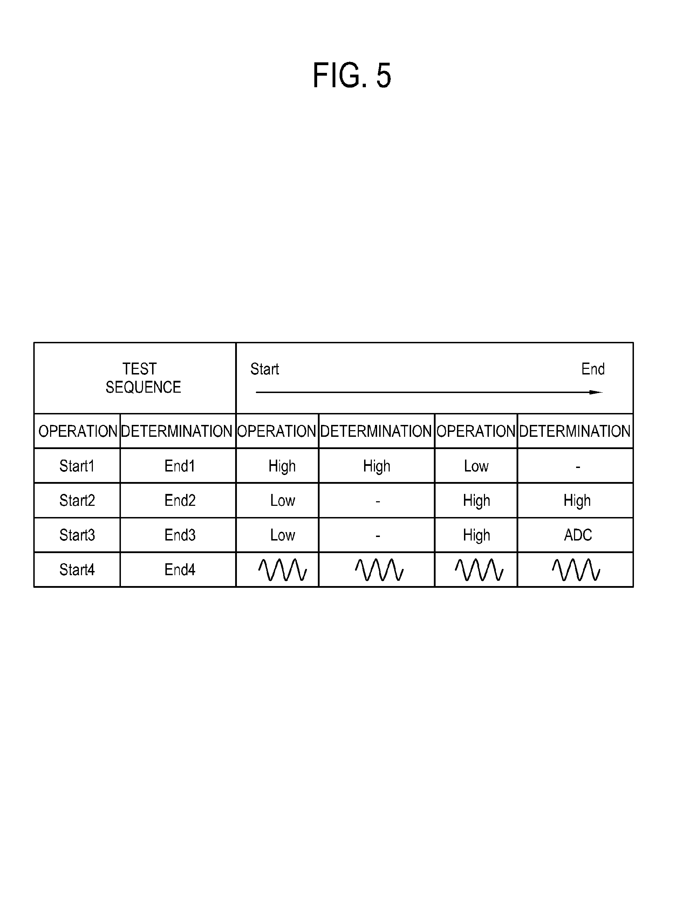

FIG. 4 illustrates a test signal applied between a signal processor 41 and a connector 42 short-circuited by a short-circuit assistor according to an exemplary embodiment. FIG. 5 illustrates an example of a test result from applying the test signal of FIG. 4.

In this exemplary embodiment, the connector 42 may be a terminal for a high definition multimedia interface. If the connector 42 is short-circuited by the short-circuit assistor 6, the signal processor 41 outputs four test signals to the connector 42. As illustrated in FIG. 4, a first test signal "Start 1" may be output to a 10^{th} pin and passes via a 6^{th} pin and a 4th pin in sequence, so that the first test signal "End 1" can be received through a 12th pin. A second test signal "Start 2" is output to a 1^{st} pin and passes through a 9^{th} pin and a 7^{th} pin in sequence, so that the second test signal "End 2" can be received through a 4^{th} pin. A third test signal "Start 3" is output to a 18^{th} pin and the third test signal "End 3" is received through a 20^{th} pin. The 18^{th} pin is not only short-circuited with the 20^{th} pin by the short-circuit assistor 6, but also short-circuited with the 13^{th} and 14^{th} pins. The fourth test signal "Start 4" is output to a 15^{th} pin, so that the fourth test signal "End 4" can be received through a 17^{th} pin. The 2^{nd}, 5^{th}, 8^{th}, 11^{th}, 16^{th} and 19^{th} pins of the connector may be provided for ground.

Referring to Fig. 5, all the first to fourth test signals may be simultaneously output, and applied a total of two times: once in the form of a high signal and once in the form of a low signal. As illustrated in Fig. 5, if the test signal is applied in the form of the high signal and received as the high signal, it may be determined that the connector 2 operates normally. On the other hand, if the test signal is applied in the form of the low signal, determination may not be performed.

In the case of a third test signal "Start 3", voltage is varied depending on registers used in a 13^{th} pin and a 14^{th} pin, and thus an ADC port is used to determine whether the received third test signal "END 3" is normal or abnormal. In the case of a fourth test signal, a square wave, a sine wave of the like having a predetermined frequency may be output, and the frequency, a duty ratio, etc. is recognized to determined whether the fourth test signal "END" 4 is normal or abnormal.

The signal processor 4 may use a interior pattern generator 9 to display whether the connector 2 is normal or abnormal, on the display 8.

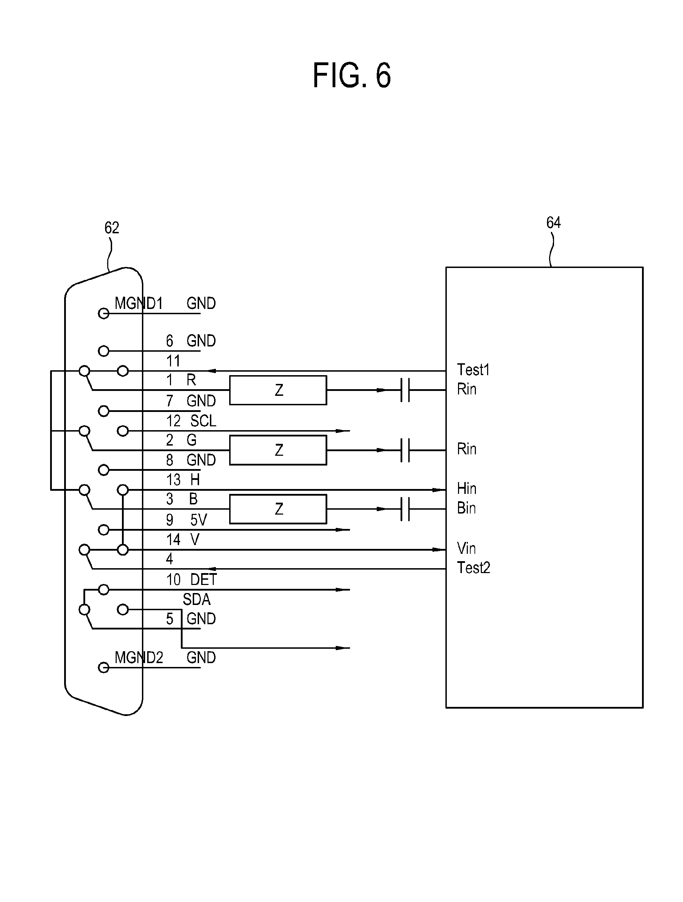

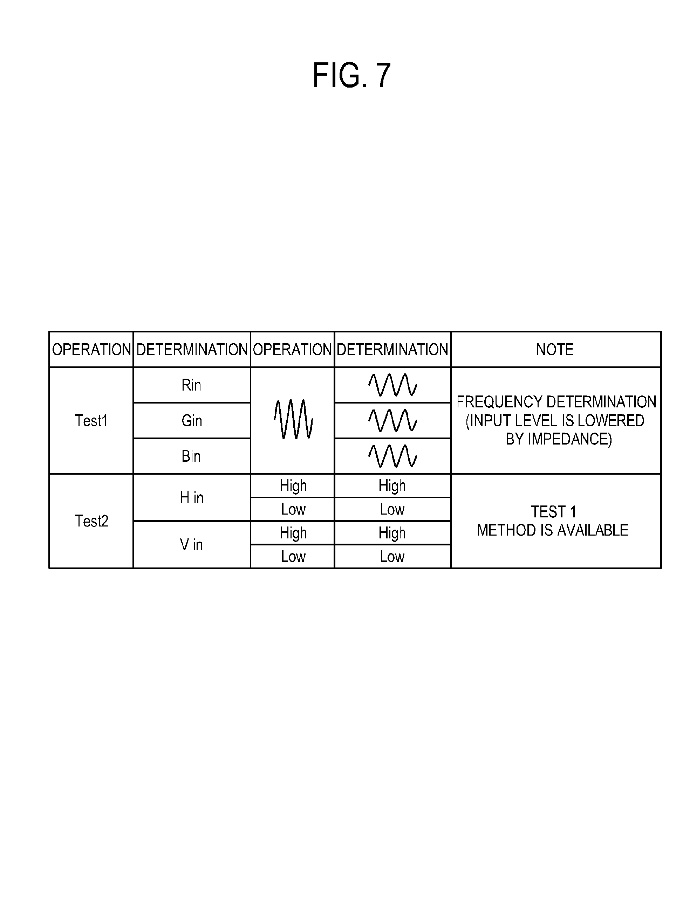

FIG. 6 illustrates a test signal is applied between a signal processor and a connector short-circuited by a short-circuit assistor according to an exemplary embodiment. FIG. 7 illustrates an example of a test result from applying the test signal of FIG. 6.

The connector 2 may be a terminal such as D-sub.

If the connector 62 is short-circuited by the short-circuit assistor 6, the signal processor 64 transmits the test signal to the connector 62. As illustrated in FIG. 6, the first test signal "Test 1" is output to the 11^{th} pin, and received as the first test signals (R, G and B input) through the 1^{st} pin, the 2^{nd} pin and the 3^{rd} pin, simultaneously. The second test signal "Test 2" is output to the 10^{th} pin, and received as the second test signals (H & V input) through the 13^{th} pin and the 14^{th} pin, simultaneously. The MGND1, 6^{th}, 7^{th}, 8^{th}, 5^{th} pins of the connector may be provided for ground The 1^{st}, 2^{nd}, 3^{rd} pins may be provided for the R, G and B signals for an image, and the 13^{th} and 14^{th} pins may be provided for horizontal/vertical frequencies. Thus, the pins 3 of the connector 62 are sorted in accordance with the kind of signals, and short-circuited by the short-circuit assistor 6.

Referring to FIG. 7, both the first to second test signals are output at a same time. The test signal is an analog signal, and it may be determined whether the connector 62 is normal or abnormal with respect to the frequencies. With an analog signal, impedance between the signal processor 64 and the connector 62 may cause an input level to be lowered. On the other hand, the second test signal is a digital signal, and may be output twice, once as a high signal and another as a low signal, but not limited thereto. Alternatively, the second test signal may be an analog signal like the first test signal. For example, if the electronic apparatus is a display apparatus, a graphic card or a signal generator may be connected as an external device. Thus, a signal generated by the external device is displayed. A user may test whether the connector is normal or abnormal an visually observe the results. However, according to an exemplary embodiment of the present invention, an external device is not needed to determine whether the connector is defective. The test may be achieved such that the signal internally generated in the electronic apparatus is output and received via a closed circuit that is formed as the pins are short-circuited by the short-circuit assistor.

Accordingly, it is possible to reduce costs of production equipment. It is possible to also shorten a time taken in detection of defects and inspection since the determination may be based, not on a visual inspection, but by an automated inspection. Further, time to connect and disconnect the external device generate and input an input signal is not required, thereby improving productivity.

According to an exemplary embodiment, the signal processor includes a pattern generator to display an image having a predetermined pattern on the display 8 so that a worker can check up whether the connector 2 is detective.

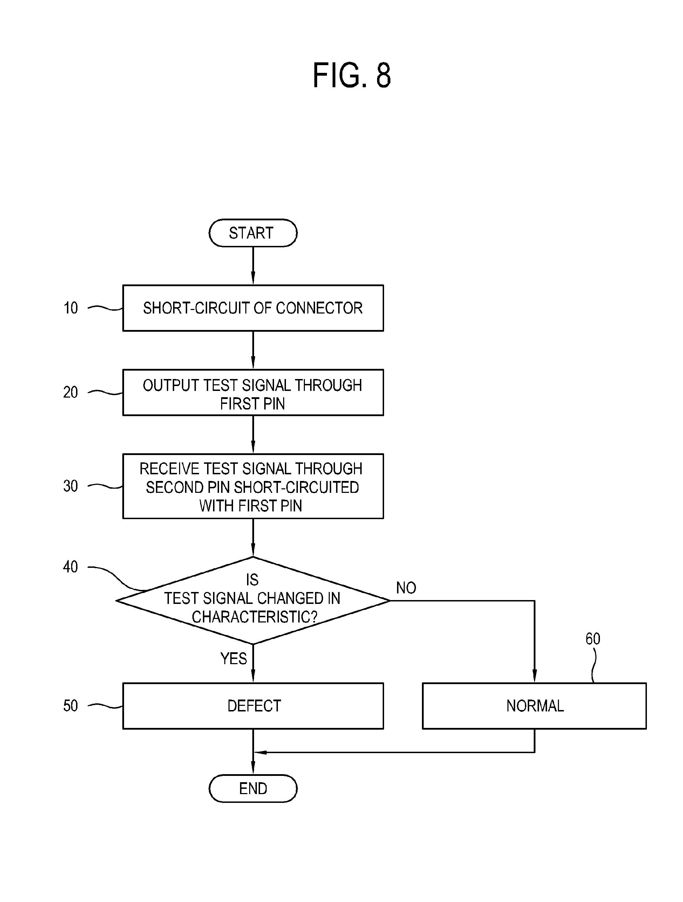

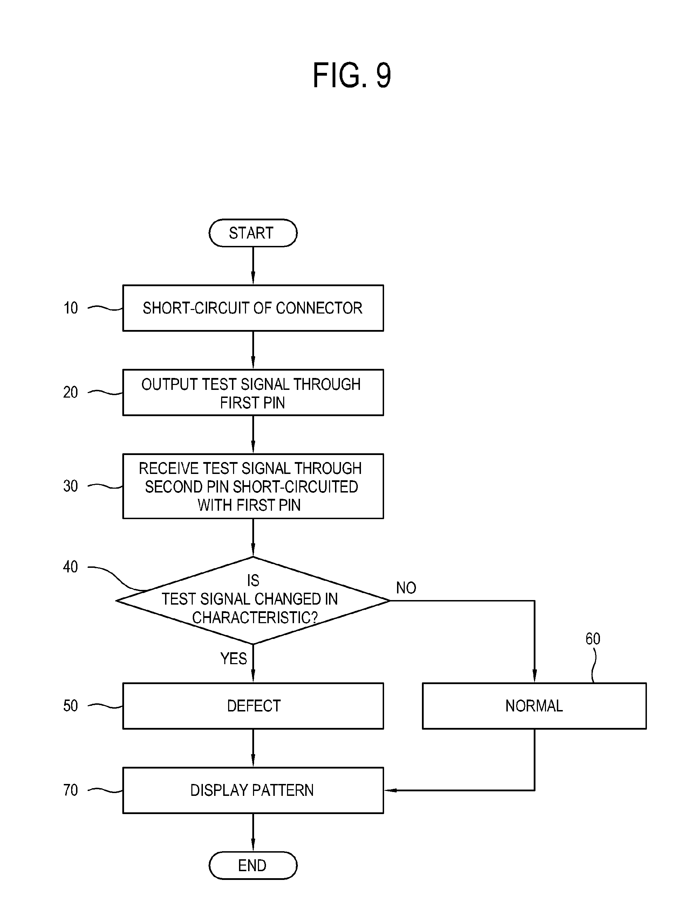

An exemplary method of controlling the electronic apparatus is described with reference to FIGs. 8 and 9.

FIG. 8 illustrates an exemplary control flowchart of an electronic apparatus according to an exemplary embodiment.

Two or more pins e.g., pins provided in the connector, e.g., connector and capable of transmitting and receiving a signal with the external device are short-circuited (operation 10). The short-circuit of the pins may be achieved by covering and coupling the connector with the short-circuit assistor, e.g., short-circuit assistor 6 provided as a cover separately from the electronic apparatus. The short-circuit assistor may have a structure for sorting and short-circuiting two or more pins in accordance with characteristics of the signals passing through the pin.

Under control of the controller, e.g., controller 5, the signal processor, e.g., signal processor generates the test signal to the first pin among two or more pins (operation 20). The test signal may be generated based on the information stored in the storage, e.g., storage 7. The test signal may be a digital signal, and the characteristic of the test signal may be a digital value. On the other hand, the test signal may be an analog signal, and the characteristic of the test signal may be a frequency. The test signal may include a plurality of test signals corresponding to the number of closed circuits formed as the pins are short-circuited, and they may be output together or separately.

The signal processor receives the test signal through the second pin short-circuited with the first pin (operation 30).

The controller 5 determines whether the characteristic (the frequency, digital value, etc.) of the test signal is changed (operation 40).

If the test signal is changed in characteristic, the controller 5 determines that the connector 2 is defective (operation 50).

On the other hand, if the characteristics of the test signal are not changed, the controller 5 determines that the connector 2 is not defective, but is normal (operation 60).

FIG. 9 is an exemplary control flowchart of an electronic apparatus according to an exemplary embodiment.

According to this exemplary embodiment, a control method of the electronic apparatus includes an operation of displaying a predetermined pattern regarding whether a connector is defective (operation 70), in addition to the operations illustrated in FIG. 8. An electronic apparatus may include a display, and a signal processor and pattern generator.

According to an exemplary embodiment, an external device is not needed for determining whether a connector is defective. The test may be achieved in such a manner that the signal generated and output by the electronic apparatus, and received via the closed circuits formed as the pins are short-circuited by the short-circuit assistor. Accordingly, it is possible to reduce costs of production equipment, and it is possible to shorten the time taken in detection for defects and inspection since the determination is based, not on a visual inspection, , but on an automated inspection. Further, there is no time required to connect and disconnect an external device and generate and input an input signal, thereby improving productivity. According to an exemplary embodiment, an electronic apparatus and a control method thereof are provided in which time taken to test the connector of the electronic apparatus is shortened to thereby improve productivity.

Although a few exemplary embodiments have been shown and described, it will be appreciated by those skilled in the art that changes may be made in these exemplary embodiments without departing from the principles of the invention, the scope of which is defined in the appended claims.

## Claims

1. An electronic apparatus comprising:
a connector comprising two or more pins to be connected with an external device and transmits and receives a signal to and from the external device;
a signal processor that generates a test signal for testing the connector and outputs the test signal to a first pin among the two or more pins; and
a controller that determines whether the connector is defective in accordance with characteristics of the test signal received through a second pin short-circuited with the first pin by a short-circuit assistor among the two or more pins.

2. The electronic apparatus according to claim 1, further comprising a short-circuit assistor.

3. The electronic apparatus according to claim 2, wherein the short-circuit assistor has a structure for sorting and short-circuiting the two or more pins in accordance with characteristics of the output test signals.

4. The electronic apparatus according to claim 2 or 3, wherein the short-circuit assistor has a structure shaped like a cover provided separately from the electronic apparatus and connected to the connector.

5. The electronic apparatus according to any one of the preceding claims, further comprising a display,
wherein whether the connector is defective is output to and displayed on the display.

6. The electronic apparatus according to any one of the preceding claims, further comprising a storage that stores information about the test signal.

7. The electronic apparatus according to any one of the preceding claims, wherein the test signal comprises a digital signal having a digital value or an analog signal having a frequency.

8. The electronic apparatus according to any one of the preceding claims, wherein the test signal comprises at least one test signal, and is output to the two or more pins at a time.

9. A control method of an electronic apparatus having a connector, comprising:
short-circuiting two or more pins that are to be connected with an external device and transmit and receive a signal to, and from, the external device;
generating a test signal for testing the connector and outputting the test signal to a first pin among the two or more pins; and
determining whether the connector is defective in accordance with characteristics of the test signal received through a second pin short-circuited with the first pin by a short-circuit assistor among the two or more pins.

10. The control method according to claim 9, wherein the short-circuiting the two or more pins comprises connecting the short-circuit assistor to the connector.

11. The control method according to claim 10, wherein the short-circuit assistor sorts and short-circuits the two or more pins in accordance with characteristics of the output test signals.

12. The control method according to claim 10 or 11, wherein the short-circuit assistor is provided separately from the electronic apparatus and connected to the connector.

13. The control method according to any one of claims 9 to 12, wherein the electronic apparatus comprises a display, and
wherein the connector is defective is output to and displayed on the display.

14. The control method according to any one of claims 9 to 13, further comprising storing information about the test signal,
wherein the outputting the test signal comprises generating the test signal based on the stored information.

15. The control method according to any one of the claims 9 to 14, wherein the test signal comprises at least one test signal, and is output to the two or more pins at a time.
